# EUROPÄISCHE PATENTSCHRIFT

(11) **EP 0 872 164 B1**
(45) Veröffentlichungstag und Bekanntmachung des Hinweises auf die Patenterteilung: **24.11.1999**
(21) Anmeldenummer: 96944062.7
(22) Anmeldetag: 23.12.1996
(51) Int. Cl.: H05H 1/46, H01J 37/32

(54) **VORRICHTUNG ZUR ERZEUGUNG VON PLASMEN MITTELS MIKROWELLEN**
DEVICE FOR THE PRODUCTION OF PLASMAS BY MICROWAVES
DISPOSITIF POUR PRODUIRE DES PLASMAS PAR HYPERFREQUENCE

(30) Priorität: 05.01.1996 DE 19600223
(43) Veröffentlichungstag der Anmeldung: 21.10.1998
(73) Patentinhaber: Spitzl, Ralf, 53639 Königswinter (DE)
(72) Erfinder: Aschermann, Benedikt, D-42111 Wuppertal (DE)
(74) Vertreter: Flaccus, Rolf-Dieter, Dr.
(86) Internationale Anmeldenummer: EP9605821
(87) Internationale Veröffentlichungsnummer: WO9725837

(56) Entgegenhaltungen:
- EP-A- 0 295 083
- EP-A- 0 564 359
- EP-A- 0 593 931
- WO-A-94/21096
- DE-U- 9 405 808
- US-A- 3 577 207

## Beschreibung

Plasmen von unterschiedlicher Art werden nach zahlreichen Verfahren erzeugt und z.B. für die Modifikation von Substraten verwendet. Die Plasmabehandlung dient z.B. der Beschichtung, Reinigung und Ätzung von Substraten, in der Medizin zur Behandlung von Implantaten sowie in der Technik zur Abgasreinigung. Die Geometrie der zu behandelnden Werkstücke reicht von flachen Substraten, Faserbündeln oder banförmigen Materialien bis zu Formteilen von beliebiger Gestalt. Durch hohe Wirkungsgrade und gute Verfügbarkeit von Mikrowellenerzeugern besitzen Mikrowellenplasmen erhebliche Bedeutung.
Verschiedene Apparate zur Plasmabehandlung sind bekannt. Darin werden Mikrowellen über eine Zuleitung und ggf. eine Kopplung in eine Plasmakammer eingestrahlt. Unterschiedliche Plasmen dienen verschieden Anwendungen. Für die Zuleitung der Mikrowellen werden u.a. Hohlleiter und Koaxial-Kabel, für die Kopplung u.a. Antennen und Schlitze verwendet (DE 4235914).
Zahlreiche vorrichtungen von verschiedener Art dienen der Erzeugung von Mikrowellenplasmen. Nach dem Stand der Technik enthalten die Vorrichtungen eine Plasmakammer, einen darin liegenden Rezipienten bzw. Nutzraum und einen daran ankoppelnden zuleitenden Hohlleiter, oft als umgebenden Hohlleiterresonator ausgeführt. Zweckwäßig sind diese auf einer gemeinsamen Rotationsachse angeordnet. Durch Einkopplung treten die Mikrowellen aus dem Resonator in die Plasmakammer (FR-A2 26 68 676, EP-A1 0 593 931). Es hat sich aber gezeigt, daß die bekannte Art der Einkopplung z.B. durch Schlitze parallel zu der Rotationsachse und die Ausbildung des Resonators nicht vorteilhaft ist. In nachteiliger Weise können dort, je nach Anordnung der Koppelstellen, bestimmte Feldmuster, z.B. TMOln Moden, nicht angeregt werden. Wichtige Anwendungen sind dann nicht möglich. Es bestand daher die Aufgabe, eine Vorrichtung für die homogene Anregung von möglichst zahlreichen Moden und/oder die Erzeugung eines großräumigen besonders homogenen Plasmas zu schaffen, die in einem weiten Druckbereich von 10⁻⁵ mbar bis insbesondere mehr als 1 bar arbeitet
Die Erfindung geht daher von einer Vorrichtung zur Erzeugung von Mikrowellenplasmen mit Mikrowellenerzeuger 1, einer Ankopplung 9 des Mikrowellenerzeugers an den Resonator, einer Plasmakammer 7 mit darin liegendem Rezipienten 8 und mindestens einen diese umschließenden Hohlleiterresonator 5 aus.
Gegenstand der Erfindung ist eine Vorrichtung zur Erzeugung von Mikrowellenplasmen der genannten Art, worin erfindungsgemäß die kurze Querschnittsseite des Resonators 5 parallel zur Achse der Vorrichtung bzw. parallel zur Achse der Plasmakammer 7 liegt und die Mikrowellenleistung aus dem Hohlleiterresonator 5 in die Plasmakammer 7 eingekoppelt wird. Der Resonator 5 umfaßt die Kammer 7 und hat mit der Kammer eine gemeinsame Wand, wobei der Resonator bevorzugt als Ring teilweise oder ganz die bevorzugt zylindrische Kammer umfaßt. Eine Ausbildung des Resonators 5 als Hohlleiter mit angepaßtem Abschluß ist ebenso möglich.
Zweckmäßig ist eine symetrische Anordnung von 5, 7 und 8 um eine gemeinsame Achse z, wobei nicht unbedingt Rotationssymetrie ausgebildet sein muß. Bei Notwendigkeit kann von der symetrischen einfachsten Ausbildung abgewichen werden. Der Resonator ist bevorzugt ein Ringresonator, und kann eine ovale oder annäherend rechteckige Form bzw. Kreisform besitzen. Wesentlich ist eine gestreckte Ausbildung des Querschnitts von 5 und die Ausbildung der mit der Kammer 7 gemeinsamen Wandung als die schmalste Querschnittseite des Resonators 5. Sehr bevorzugt bildet der Resonator 5 einen Ring von rechteckigem Querschnitt mit der schmalen, kurzen Rechteckseite der Kammer 7 zugewandt und als gemeinsame Wandung mit dieser ausgebildet.
Möglich ist jedoch auch die Ausbildung des Resonators 5 als Hohlleiter, der die Kammerwandung umfaßt mit z.B. im wesentlichen kreisförmigem Querschnitt.
Mehrere Resonatoren 5 mit gemeinsamer oder getrennten Mikrowellenerzeugern sind möglich und erlauben Kammern 7 von großen Abmessungen. Die Koppelstellen sind bevorzugt Schlitze, sehr bevorzugt schmale Schlitze, jedoch können auch Antennen, Schlaufen oder Verzweigungen die Koppelstellen bilden. Durch die Ausbildung der Koppelstellen in der schmalen bzw. schmalsten Seite kann die Kopplung an beliebigen Stellen der gemeinsamen Wandung von Resonator 5 und Kammer 7 um die Achse-z bzw. parallel zu dieser liegen. Erfindungsgemäß erfolgt eine vereinfachte Einkopplung mit erhöhter Energiedichte in der Plasmakammer. Dadurch ist eine verbesserte Beschichtung großer Werkstücke, verbesserte Leistung bei chemischen Reaktionen z.B. Abgasreinigung möglich.
Zweckmäßig und bevorzugt ist ein rechteckiger Querschnitt ggf. auch ein kreisförmiger Querschnitt des Resonators 5. Weiter bevorzugt ist die toroidale bzw. im wesentlichen ringförmige Ausbildung des Hohlleiterresonators 5. Nach Anspruch 2 ist es sehr bevorzugt, daß die Koppelstellen 6 als azimutal ausgerichtete Schlitzkoppler, d.h. senkrecht zur z-Achse, ausgebildet sind. Dadurch liegen die Schlitze in Richtung ihrer langen Seite, exakt bzw. annähernd auf einem Kreis um die z-Achse senkrecht zu dieser. Es ist auch möglich, daß die Schlitze auf parallelen Kreisen oder in einem Winkel von z.B. 45° hierzu liegen.
Erfindungsgemäß liegt die kurze Querschnittsseite im Falle eines rechteckigen Querschnitts des Ringresonators 5 senkrecht zu dessen radialer Richtung und parallel zur Rotationsachse der Plasmakammer 7. Die Mikrowellenkopplung über die kurze Rechteckseite von 5 hat zur Folge, daß bei der Verwendung von Koppelschlitzen in der Wand zwischen 5 und 7 diese nicht parallel zur z-Rotationsachse der Plasmakammer verlaufen dürfen. Im Fall der Verwendung von azimutalen Schlitzen in der Wand zwischen 5 und 7 wird der Ringresonator mit Paralleladmittanzen belastet.
Im Resonator 5 liegen bevorzugt die Koppelstellen 6 an den Stellen der elektrischen Feldmaxima der stehenden Welle. Länge und Abstand der Koppelstellen soll regelmäßig sein, doch besteht der Vorteil, daß nicht exakte Regelmäßigkeit nötig ist.
Die Koppelstellen liegen bevorzugt an den Stellen der gleichphasigen E-Feldmaxima der stehenden Welle. Die Länge einer Koppelstelle, vorzugsweise der Schlitze, kann der gesamten Länge einer E-Feldhalbwelle entsprechen.
Die Ankopplung kann mittels Zirkulator, Abstimmeinheit, Zuleitung und Mikrowelleneinkopplung, bevorzugt H-Verzweiger sowie E-Verzweiger, Schlaufen, Antennen o. dgl. erfolgen. Die Abstimmung der Mikrowellenkopplung von 1 nach 5 kann z.B. durch Dreistifttuner, magisches T-Stück, Abschlußschieber oder andere Abstimmelemente, auch auf der gegenüberliegenden Seite der Mikrowelleneinkopplung von 5 erfolgen.
Die Plasmakammer 7 und entsprechend der umlaufende Hohlleiterresonator 5 ist z.B. als Ringresonator zur Anregung bestimmter Moden ausgeführt und kann entsprechend in Form eines Zylinders, besonders von Kreisquerschnitt oder auch in Form eines Würfels, einer quadratischen oder rechtekkigen Säule oder dgl., auch in unregelmäßiger Form, ausgebildet sein. Die Speisung der torodialen Recheckhohlleiterresonatoren 5 kann auch durch mehrere Mikrowellenerzeuger erfolgen.
Die Kammer 7 kann mit dem zur Anregung einer TM010 Mode notwendigen Durchmesser und Höhe ausgeführt sein bzw. mit Maßen zur Anregung von TM01n (n=1,2,3,...) Moden. Aufgrund z.B. der dielektrischen Eigenschaften des Rezipienten 8 kann die Feldverteilung von der idealen TM01n (n=0,1,2,...) Feldverteilung des ungestörten Resonators 5 abweichen.
Durch zusätzliche elektrische Spulen oder Permagnentmagnete 10 kann in der Kammer 7 ein Magnetfeld erzeugt werden, wodurch eine Elektronen-Zyklotron-Resonanz zur Generierung hoher Ionendichten bei niedrigen Rezipientendrükken von etwa < 10⁻² hPa erreicht wird.

In Abhängigkeit der Ausbildung des verwendeten Rezipienten 8 aus z.B. Quarzglas in der Plasmakammer, kann für die Plasmaerzeugung zum einen das Nahfeld der Einkoppelstellen z.B. als Schlitzantennen oder Stabantennen, oder bei entsprechenden Abmessungen der Plasmakammer, ein für den Anwendungsfall gewünschte Resonatormode, z.B. TM01n mit n=0,1,2... bei Zylinderresonatoren, ausgenutzt werden. Bei der TM010 Mode des Zylinderresonators wird ein langgestrecktes Plasma entlang der z-Achse erzeugt. Bei TM01n mit n>0 sind die Durchmesser in Abhängigkeit zur Länge des Resonators wählbar und große Plasmavolumina erreichbar.

Der Mikrowellenerzeuger hat z.B. eine Magnetron-Vakuumröhre der Frequenz: 2,45 GHz.

Bei der Anregung von Mikrowellenmoden in der Plasmakammer, z.B. die Zylindermoden TMOln mit n = 0,1,2 ..., sind die Schlitze so zu wählen, daß sie vor den gleichphasigen Maxima der Ringresonatormode angeordnet sind. Im Falle der Ausnutzung des Nahfeldes der Schlitzkoppler für die Erzeugung des Plasmas ist es jedoch ebenso möglich, die Schlitze bei jedem Maximum anzuordnen. Die Länge der Koppelschlitze sollen die Bereiche gleicher Phase nicht überschreiten, für maximale Leistungseinkopplung soll die Länge genau die Halbwellen abdecken.
Alle Bauteile können auch mehrfach in der Vorrichtung vorhanden sein.
In der Zeichnung wird die Erfindung durch Ausführungsbeispiele erläutert.
Fig.1 zeigt eine erfindungsgemäße Vorrichtung im Schnitt mit darin liegenden Achsen x und z.
Fig.2 eine Aufsicht dieser Vorrichtung in Richtung der z-Achse und
Fig.3 den Schnitt einer erfindungsgemäßen Vorrichtung mit Ankopplung von drei Resonatoren 5 an einen gemeinsamen Mikrowellenerzeuger 1 und einer gemeinsamen Plasmakammer 7.

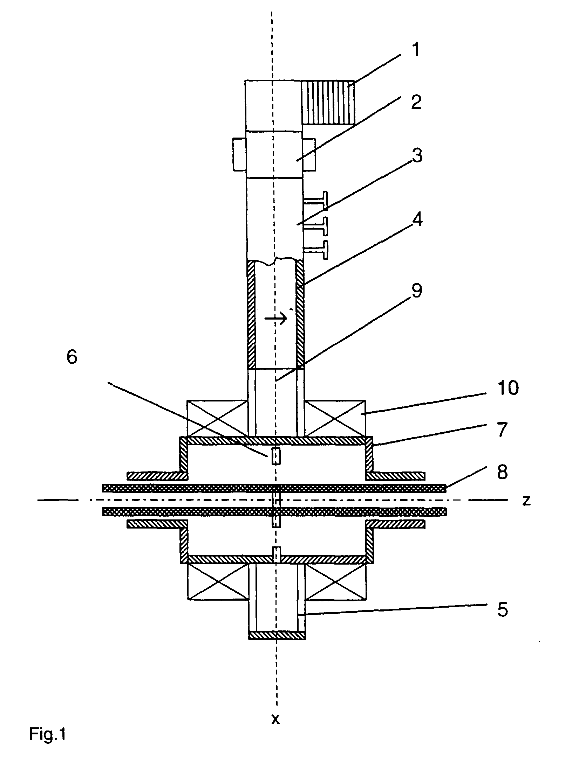

In Fig. 1 liegt ein ringförmiger Hohlleiterresonator 5 mit der kurzen Seite seines rechteckigen Querschnitts in der Zylinderwand der Plasmakammer 7 und wird aus einem Mikrowellenerzeuger 1 über eine Ankopplung 2,3,4,9 aus Zirkulator 2, Abstimmeinheit 3 z.B. 3-Stifttuner, Zuleitung 4 und Mikrowellen-Einkoppelstelle 9 z.B. als H-Verzweiger oder E-Verzweiger mit Mikrowellen versorgt. Der Pfeil in der Zeichnung zeigt die Richtung des E-Feldes an, x und z bezeichnen die Achsen. Die in der Projektion angedeuteten Koppelschlitze 6 durchdringen auf der kurzen Seite des rechteckigen Querschnitts den Ringresonator 5 dessen gemeinsame Wand mit der Plasmakammer 7. Magnetspulen 10 bewirken in diesem Falle eine Elektronen-Zyklotron-Resonanz-Anregung.

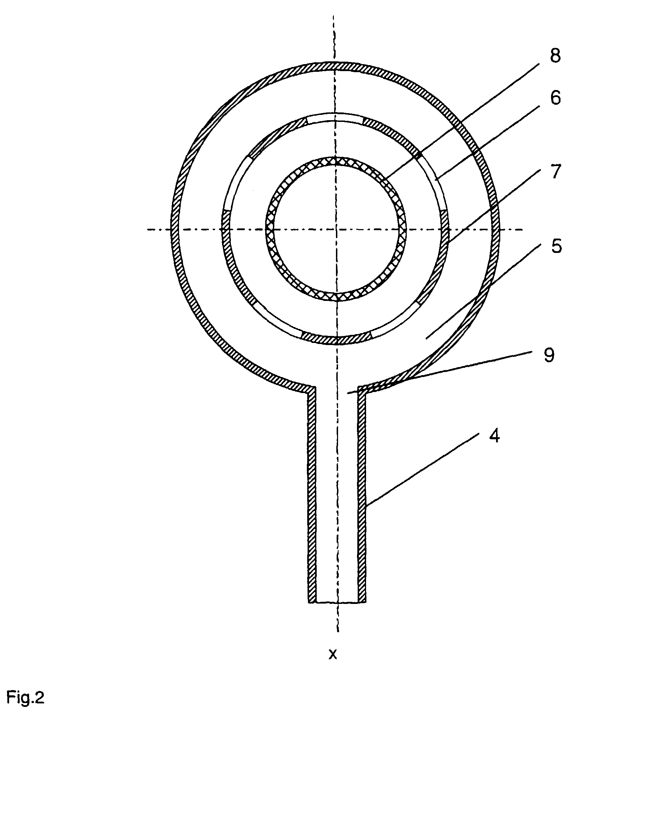

In Fig.2 koppeln, entsprechend der in Fig.1 gezeigten Schlitze 6 in der ringförmigen Wand des Resonators 5, die Mirkrowellen in die Kammer 7 mit Rezipienten 8. Im Ringresonator 5 stehen die E-Feldvektoren senkrecht zur Zeichnungsebene.

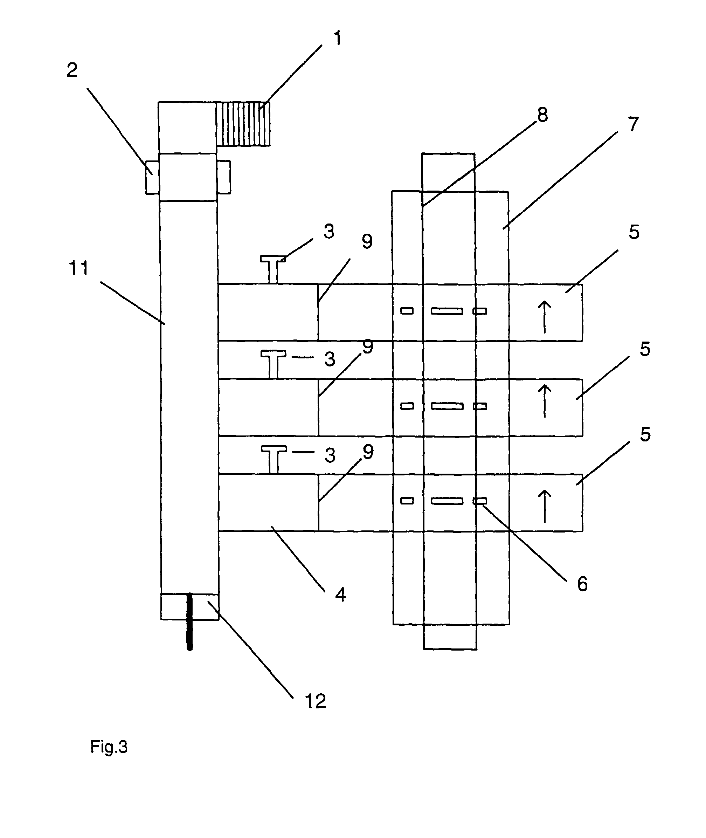

In Fig. 3 erfolgt über die Zuleitung durch den Speiseresonator 11 eine dreifache bevorzugt phasengleiche Ankopplung von torodialen Rechteckhohlleiterresonatoren 5 an eine Plasmakammer 7. Zur Abstimmung des Speiseresonators dient ein Kurzschlußschieber 12. Mit den Stifttunern 3 werden Resonatoren 5 abgestimmt. Die Pfeile zeigen die Ausrichtung des E-Feldes im Ringresonator an, welche erfindungsgemäß parallel zur z-Achse und senkrecht zu den Mikrowellenkoppelschlitzen steht.

## Patentansprüche

1. Vorrichtung für die Erzeugung von Mikrowellenplasmen mit Plasmakammer und Resonator, dadurch gekennzeichnet, daß die kurze Querschnittsseite des Resonators (5) der gemeinsamen Achse (z) zugewandt in der Wand zwischen Resonator (5) und Plasmakammer (7) liegt und die Mikrowellenleistung aus dem Resonator (5) über Koppelstellen (6) in der kurzen Seite des Querschnitts von Resonator (5) in die Kammer (7) eingekoppelt ist.

2. Vorrichtung nach Anspruch 1, dadurch gekennzeichnet, daß die Koppel stellen (6) als azimutal ausgerichtete Schlitzkoppler in der gemeinsamen Wand von (5) und (7) ausgebildet sind.

3. Vorrichtung nach Anspruch 1, dadurch gekennzeichnet, daß die Koppelstellen (6) als Antennen oder als Schlaufen in der gemeinsamen Wand von (5) und (7) ausgeführt sind.

4. Vorrichtung nach einem der Ansprüche 1 bis 3, dadurch gekennzeichnet, daß die Plasmakammer (7) als Mikrowellenresonator in Form eines Würfels, Quaders, einer quadratischen- oder rechteckigen Säule, eines Zylinders oder dgl. ausgeführt ist.

5. Vorrichtung nach einem der Ansprüche 1 bis 4, dadurch gekennzeichnet, daß durch zusätzliche elektrische Spulen oder Permanentmagnete (10) ein Magnetfeld in der Kammer (7) erzeugt wird.

6. Vorrichtung nach einem der Ansprüchen 1 oder 3, dadurch gekennzeichnet, daß der Resonator (5) die Kammer (7) umfaßt.

## Claims

1. Device for the production of microwave plasmas with a plasma chamber and a resonator, characterized in that the short cross-sectional side of the resonator (5) lies facing the common axis (z) in the wall between the resonator (5) and the plasma chamber (7), and the microwave power is coupled from the resonator (5) into the chamber (7) via coupling points (6) in the short side of the cross-section of the resonator (5).

2. Device according to Claim 1, characterized in that the coupling points (6) are formed as azimuthally oriented slot couplers in the common wall of (5) and (7).

3. Device according to Claim 1, characterized in that the coupling points (6) are formed as antennas or loops in the common wall of (5) and (7).

4. Device according to one of Claims 1 to 3, characterized in that the plasma chamber (7) is designed as a microwave resonator in the form of a cube, cuboid, a square or rectangular column, a cylinder or the like.

5. Device according to one of Claims 1 to 4, characterized in that a magnetic field is produced in the chamber (7) by additional electrical coils or permanent magnets (10).

6. Device according to one of Claims 1 or 3, characterized in that the resonator (5) encloses the chamber (7).

## Revendications

1. Dispositif pour la création de plasmas par hyperfréquence, comportant une chambre à plasma et un résonateur, caractérisé en ce que le court côté de la section transversale du résonateur (5) est tourné vers l'axe commun (z) et situé dans la paroi entre le résonateur (5) et la chambre à plasma (7), et la puissance des hyperfréquences provenant du résonateur (5) est couplée dans la chambre (7) par l'intermédiaire d'emplacements d'accouplement (6) prévus dans le court côté de la section transversale du résonateur (5).

2. Dispositif selon la revendication 1, caractérisé en ce que les emplacements d'accouplement (6) sont configurés comme dispositifs d'accouplement en fente d'orientation azimutale dans la paroi commune de (5) et (7).

3. Dispositif selon la revendication 1, caractérisé en ce que les emplacements d'accouplement (6) sont configurés comme antennes ou comme boucles dans la paroi commune de (5) et (7).

4. Dispositif selon l'une des revendications 1 à 3, caractérisé en ce que la chambre à plasma (7) est configurée comme résonateur hyperfréquence sous forme d'un cube, d'un parallélépipède rectangle, d'une colonne carrée ou rectangulaire, d'un cylindre ou similaire.

5. Dispositif selon l'une des revendications 1 à 4, caractérisé en ce qu'un champ magnétique est créé dans la chambre (7) par des bobines électriques supplémentaires ou des aimants permanents (10).

6. Dispositif selon l'une des revendications 1 ou 3, caractérisé en ce que le résonateur (5) entoure la chambre (7).
